# EUROPEAN PATENT APPLICATION

(11) **EP 3 967 547 A2**
(43) Date of publication of application: **16.03.2022**
(21) Application number: 21195616.4
(22) Date of filing: 08.09.2021
(51) Int. Cl.: B60L 53/30, B60L 55/00, B60L 58/12, B60L 58/14, B60L 53/63, B60L 53/66

(54) **ELECTRIC POWER MANAGEMENT APPARATUS AND ELECTRIC POWER MANAGEMENT SYSTEM IN A VEHICLE-TO-GRID (V2G) DEMAND REQUEST CONTEXT**

(30) Priority: 15.09.2020 JP 2020154803
(71) Applicant: HONDA MOTOR CO., LTD., Minato-ku Tokyo 107-8556 (JP)
(72) Inventor: OGAWA, Makoto, Saitama, 351-0193 (JP)
(74) Representative: Weickmann & Weickmann PartmbB

(57) **Abstract**

An electric power management apparatus that manages electric power in a facility configured to be electrically connectable to a vehicle including a battery, the electric power management apparatus comprising a calculation unit that calculates a degree of charging or discharging executable for the battery, an instruction unit that gives an instruction on the charging or discharging, an acquisition unit that acquires a degree of the charging or discharging that is actually being executed in response to the instruction of the instruction unit, and a stopping unit that stops the charging or discharging executed in response to the instruction of the instruction unit on the basis of a difference between the calculated degree and the acquired degree.

## Description

### BACKGROUND OF THE INVENTION

### Field of the Invention

The present invention relates to mainly an electric power management apparatus.

### Description of the Related Art

While a vehicle including a battery such as an electric vehicle is stopped in a facility such as a home or an office, a user can charge the battery of the vehicle by using a terminal installed in the facility (see Japanese Patent No. 6242006). For charging the battery, not only electric power (commercial electric power) from an electric power system can be used, but also electric power generated in the facility, for example, electric power generated by an electric power generation device such as a solar power generation device can be used.

In the above configuration, the battery can be utilized as a storage battery, and for example, the electric power of the battery can be used instead of the electric power from the electric power system on the basis of the supply and demand balance of the electric power in the facility (see Japanese Patent No. 6402256).

A technique for appropriately utilizing the battery in the above configuration is required. However, it is considered that the appropriate utilization of the battery becomes difficult due to an unexpected environmental change.

### SUMMARY OF THE INVENTION

The present invention makes it possible to appropriately utilize a battery of a vehicle electrically connected to a facility.

One of the aspects of the present invention provides an electric power management apparatus that manages electric power in a facility configured to be electrically connectable to a vehicle including a battery, the electric power management apparatus comprising a calculation unit that calculates a degree of charging or discharging executable for the battery, an instruction unit that gives an instruction on the charging or discharging, an acquisition unit that acquires a degree of the charging or discharging that is actually being executed in response to the instruction of the instruction unit, and a stopping unit that stops the charging or discharging executed in response to the instruction of the instruction unit on the basis of a difference between the calculated degree and the acquired degree.

Further features of the present invention will become apparent from the following description of exemplary embodiments (with reference to the attached drawings).

### BRIEF DESCRIPTION OF THE DRAWINGS

FIG. 1 is a schematic diagram for explaining a configuration example of an electric power management system in a certain facility;
FIG. 2 is a timing chart for explaining an example of a mode of electric power management;
FIG. 3 is a schematic diagram illustrating a communication mode between an electric power management apparatus and an aggregator;
FIG. 4 is a schematic diagram illustrating the discharge characteristic of the electric power of a battery; and
FIG. 5 is a flowchart illustrating an example of an electric power management method of the electric power management apparatus.

### DESCRIPTION OF THE EMBODIMENTS

Hereinafter, embodiments will be described in detail with reference to the attached drawings. Note, the following embodiments are not intended to limit the scope of the claimed invention, and limitation is not made to an invention that requires a combination of all features described in the embodiments. Two or more of the multiple features described in the embodiments may be combined as appropriate. Furthermore, the same reference numerals are given to the same or similar configurations, and redundant description thereof is omitted.

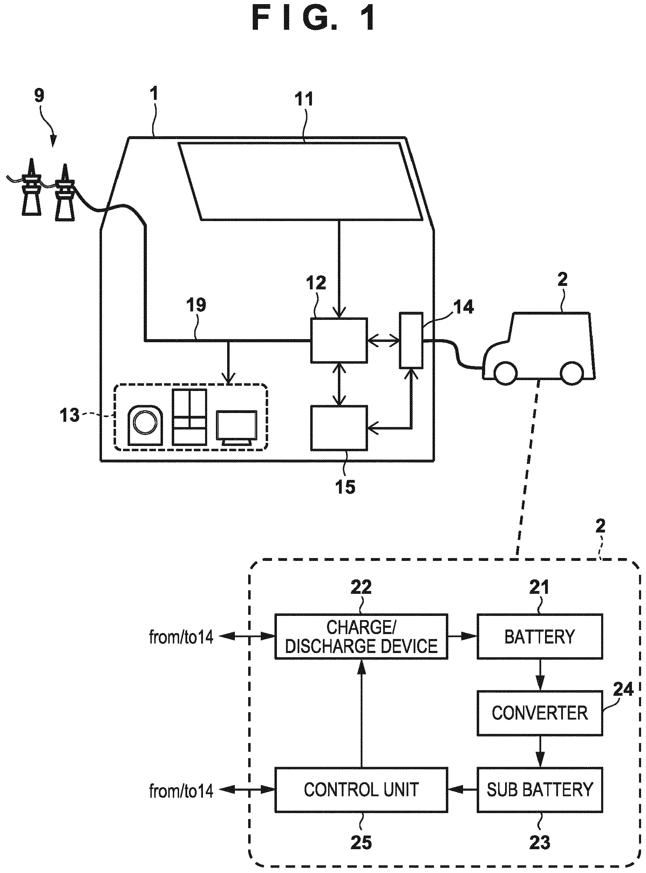

FIG. 1 illustrates a configuration example of an electric power management system SY of a facility 1 according to an embodiment. The facility 1 is configured to be able to receive electric power (commercial electric power) from an electric power system 9, and includes an electric power generation device 11, an inverter 12, an electric device group 13, a vehicle connection mechanism 14, and an electric power management apparatus 15. For simplification of description, the facility 1 is a private house in this embodiment, but may be an apartment house such as an apartment, an office such as a company, or a commercial facility such as a supermarket as another embodiment. The electric power system 9 is a system that performs electric power generation, electric power transformation, electric power transmission, and electric power distribution to realize electric power supply to individual customers (including the facility 1), and is a concept including an electric power company, an electric power generation plant, a substation, an electric power transmission line, and the like. The facility 1 can purchase electric power from the electric power system 9, and the electric power is supplied to an electric power line 19 in the facility 1.

The electric power generation device 11 generates other electric power different from the electric power of the electric power system 9. In this embodiment, the electric power generation device 11 is a solar power generation device (solar panel) that generates electric power on the basis of sunlight, but as another embodiment, for example, other renewable energy such as water power, wind power, and geothermal heat may be used.

The inverter 12 is also referred to as a power conditioner or the like, and can convert electric power (for example, DC voltage) obtained by the electric power generation device 11 to electric power (for example, AC voltage) corresponding to the facility 1 and supply the converted electric power to the electric power line 19.

The electric device group 13 includes one or more electric devices operable on the basis of the electric power of the electric power line 19, and its/their typical examples include a TV, a refrigerator, a washing machine, an air conditioner, and the like. The electric device group 13 may be expressed as an intra-facility electric power load or simply as a load or the like.

The vehicle connection mechanism 14 is configured to connect a vehicle 2 to the facility 1. The above-described inverter 12 can selectively realize the bidirectional electric power supply between the facility 1 and the vehicle 2 via the vehicle connection mechanism 14. That is, the inverter 12 includes a converter that converts electric power to corresponding one for the electric power supply between the facility 1 and the vehicle 2, thereby selectively supplying electric power from the electric power line 19 to the vehicle 2 and supplying electric power from the vehicle 2 to the electric power line 19 via the vehicle connection mechanism 14. The mechanism 14 may be expressed as a connection terminal or simply as a terminal or the like. Note that although the vehicle connection mechanism 14 is illustrated as a part of the facility 1 in FIG. 1 for ease of description, a part/all of the vehicle connection mechanism 14 can be installed outdoors (for example, in a parking lot).

The electric power management apparatus 15 performs electric power management in the facility 1 while monitoring the state of the electric power line 19 via, for example, an ammeter or the like, and is configured to be able to give an instruction on the electric power supply between the facility 1 and the vehicle 2 on the basis of, for example, the supply and demand balance of the electric power in the facility 1, details of which will be described later. In this embodiment, the electric power management apparatus 15 includes a central processing unit (CPU), a memory, and a communication interface, and performs the electric power management on the basis of a predetermined program, but the function can be realized by either software or hardware. In addition, the electric power management apparatus 15 includes a communication device, thereby making it possible to realize the communication between the facility 1 and the vehicle 2 via the vehicle connection mechanism 14.

Although details will be described later, the electric power management apparatus 15 can receive a request for the provision of electric power from the electric power system 9 by the communication device, and can execute electric power management on the basis of the request. The request from the electric power system 9 is typically made by an intermediary (aggregator) that mediates the exchange of electric power between the facility 1 and the electric power system 9, and may also be referred to as a demand response (Hereinafter, it may be referred to as a "DR".).

Note that, here, each element in the facility 1 is individually illustrated to distinguish functions, but the present invention is not limited to the configuration of this example, and some elements may be configured of a single unit, and a certain element may be configured of a plurality of units. For example, the inverter 12 and the electric power management apparatus 15 may be configured of a single unit, or a part of the function of the vehicle connection mechanism 14 may be realized by the inverter 12.

In this embodiment, the vehicle 2 is an electric vehicle (EV) including a battery 21, and further includes a charge/discharge device 22, a sub battery 23, a converter 24, and a control unit 25. For the battery 21, for example, a lithium ion battery having an output voltage of about 200 [V] is used. The charge/discharge device 22 includes a bidirectional inverter, a relay, and the like, and the vehicle 2 is electrically connected to the facility 1 by the vehicle connection mechanism 14, so that the bidirectional electric power supply between the facility 1 and the vehicle 2 can be selectively executed. For example, the charge/discharge device 22 supplies the electric power of the electric power line 19 to the battery 21 (charges the battery 21), or supplies the electric power of the battery 21 to the electric power line 19 (discharges the battery 21).

As the sub battery 23, for example, a lead-acid battery having an output voltage of about 12 [V] can be used. The converter 24 converts the electric power of the battery 21 to electric power corresponding to the sub battery 23 to be able to charge the sub battery 23. That is, the sub battery 23 receives and stores the electric power from the battery 21.

Regarding the relationship between the battery 21 and the sub battery 23, a secondary battery is used for both of these. The battery 21 has, as a main function, an electric power source for driving the power source (for example, an electric motor such as a three-phase induction motor) of the vehicle 2. The sub battery 23 has, as a main function, an auxiliary power supply for driving an electric system (for example, the control unit 25 described later and the like) of the vehicle 2. The battery 21 may be expressed as a main battery to be distinguished from the sub battery 23.

In this embodiment, the sub battery 23 can be charged by the electric power of the battery 21 while the charging of the battery 21 is being executed by the charge/discharge device 22. As another embodiment, the sub battery 23 may be charged by the electric power of the battery 21 while the vehicle 2 is traveling, which is suitable when the vehicle 2 is a so-called hybrid car.

The control unit 25 enters an operating state on the basis of the electric power of the sub battery 23, communicates with the electric power management apparatus 15, and drives and controls the charge/discharge device 22. Although details will be described later, for example, the control unit 25 in the operating state drives and controls the charge/discharge device 22 on the basis of a signal from the electric power management apparatus 15, thereby charging or discharging the battery 21. In addition, while the battery 21 is not charged or discharged, the control unit 25 is in a resting state (substantially non-operating state), and suppresses the electric power consumption of the sub battery 23.

Note that in this embodiment, the electric connection between the facility 1 and the vehicle 2 is realized by a single cable in the vehicle connection mechanism 14. Thus, both the electric connection between the electric power line 19 and the battery 22 via the charge/discharge device 22 and the communication between the electric power management apparatus 15 and the control unit 25 are realized.

With the above-described system SY, it is possible to appropriately manage the electric power in the facility 1 on the basis of the supply and demand balance, and from another viewpoint, it is possible to reduce the purchase of electric power from the electric power system 9 by utilizing the battery 21 of the vehicle 2 electrically connected to the facility 1. Although details will be described later, for example, the battery 21 is discharged when the demand for the electric power in the facility 1 is larger than the supply, and the battery 21 is charged when the demand for the electric power in the facility 1 is smaller than the supply. The system SY may also be referred to as a vehicle to home (V2H) control system or the like.

For example, after the vehicle 2 is electrically connected to the facility 1 and the battery 21 is brought into the utilizable state as described above, it may be necessary to use the vehicle 2 contrary to the user's prediction (regardless of the user's schedule). Therefore, it is conceivable that the user sets in advance a range that the charging rate of the battery 21 should satisfy as a target range (that is defined as R0). Thus, the battery 21 can be appropriately utilized while the vehicle 2 is electrically connected to the facility 1, that is, the bidirectional electric power supply between the facility 1 and the vehicle 2 can be selectively performed while the charging rate of the battery 21 is maintained within the target range R0.

Note that the charging rate indicates the ratio of the remaining capacity to the battery capacity of the battery 21, and can also be expressed as a state of charge (SOC). In addition, the user is typically the owner of the vehicle 2, but may be a related person or a third party who temporarily uses the vehicle 2.

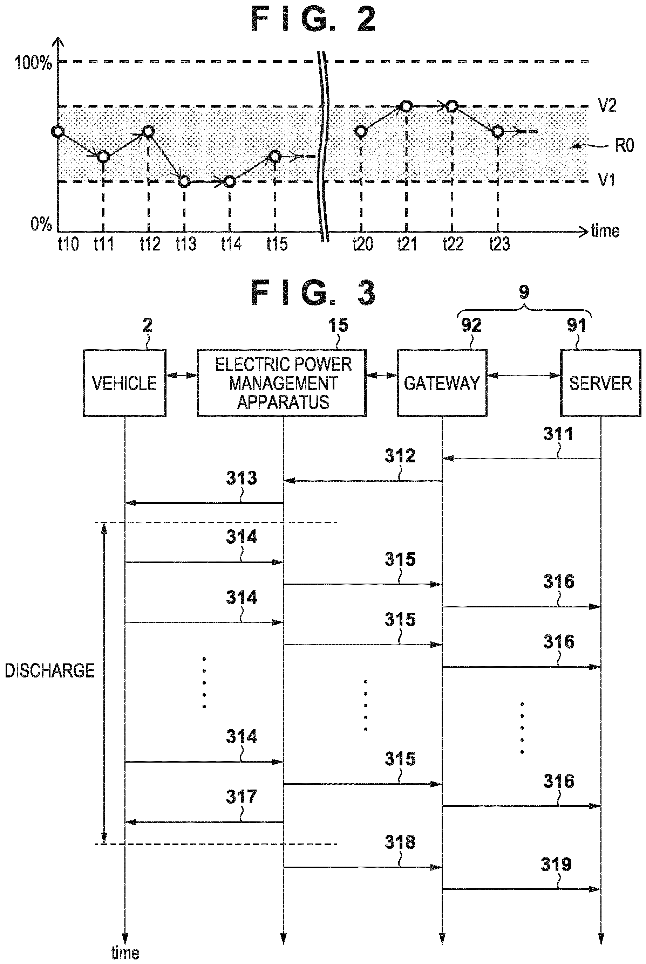

FIG. 2 is a timing chart for explaining an example of an electric power management method by the electric power management apparatus 15. The vertical axis in the drawing represents the charging rate (0 - 100[%]) of the battery 21. The horizontal axis in the drawing is a time axis. As described above, the user can set the target range R0 that the charging rate should satisfy. The target range R0 may be expressed as a utilization allowable range or simply an allowable range or the like.

A lower limit value V1 and an upper limit value V2 of the target range R0 can be arbitrarily set by the user. As an example, the lower limit value V1 can be set to 20[%] (a numerical value corresponding thereto), and the upper limit value V2 can be set to 80[%] (a numerical value corresponding thereto). As another example, the lower limit value V1 may be set to 50[%] (a numerical value corresponding thereto), and the upper limit value V2 may be set to 100[%] (a numerical value corresponding thereto).

First, it is assumed that the charging rate of the battery 21 is within the target range R0 at time t10 when the vehicle 2 is electrically connected to the facility 1 and the battery 21 can be utilized. Thereafter, the charging or discharging of the battery 21 is performed while the charging rate of the battery 21 is maintained within the target range R0, and when the charging rate of the battery 21 falls outside the target range R0 (alternatively, when it falls outside the range R0), the charging or discharging is stopped, and the battery 21 is utilized in this manner.

For example, from the time t10 to time t11, it is assumed that the electric power consumption (electric power demand) by the electric device group 13 in the facility 1 is larger than the generated electric power (electric power supply) by the electric power generation device 1 (demand > supply). Accordingly, in this embodiment, the battery 21 is discharged (that is, the shortage of the electric power in the facility 1 is compensated by the electric power of the battery 21), and electric power is not purchased from the electric power system 9 in this example. As a result, the charging rate of the battery 21 decreases.

Thereafter, from the time t11 to time t12, it is assumed that the electric power consumption in the facility 1 becomes smaller than the generated electric power by the electric power generation device 1 (demand < supply). Accordingly, in this embodiment, the battery 21 is charged (That is, the surplus of the electric power in the facility 1 is supplied to the battery 21.). As a result, the charging rate of the battery 21 increases.

Thereafter, from the time t12 to time t13, it is assumed that the electric power consumption in the facility 1 becomes significantly larger than the generated electric power by the electric power generation device 1 (demand > supply). Thus, similarly to the period from the time t10 to the time t11, the battery 21 is discharged, and here, as a result, the charging rate of the battery 21 reaches the lower limit value V1. When the battery 21 is discharged as it is (when the shortage of the electric power is compensated by using the electric power of the battery 21), the charging rate of the battery 21 falls outside the target range R0. Therefore, in such a case, the discharging of the battery 21 is stopped and electric power is purchased from the electric power system 9, and the electric power is used for the shortage of the electric power in the facility 1.

Thereafter, the charging rate of the battery 21 indicates the lower limit value V1 from the time t13 to time t14 until the electric power consumption in the facility 1 becomes smaller than the generated electric power by the electric power generation device 1 (until the supply and demand balance of the electric power in the facility 1 is reversed).

Thereafter, from the time t14 to time t15, it is assumed that the electric power consumption in the facility 1 becomes smaller than the generated electric power by the electric power generation device 1 (demand < supply). Thus, the battery 21 is charged similarly to the period from the time t11 to the time t12.

In addition, for example, it is assumed that the electric power consumption in the facility 1 becomes smaller than the generated electric power by the power generation device 1 at further subsequent time t20 to time t21 (demand < supply). Thus, similarly to the period from the time t11 to the time t12, the battery 21 is charged, and here, as a result, the charging rate of the battery 21 reaches the upper limit value V2. If the battery 21 is charged as it is, the charging rate of the battery 21 falls outside the target range R0. Therefore, in such a case, the charging of the battery 21 is stopped. Note that in such a case, the surplus of the electric power in the facility 1 may be stored in another storage battery (not illustrated) or the like in the facility 1, or may be purchased by an electric power company.

Thereafter, the charging rate of the battery 21 indicates the upper limit value V2 from the time t21 to time t22 until the electric power consumption in the facility 1 becomes larger than the generated electric power by the electric power generation device 1 (until the supply and demand balance of the electric power in the facility 1 is reversed).

Thereafter, from the time t22 to time t23, it is assumed that the electric power consumption in the facility 1 becomes larger than the generated electric power by the electric power generation device 1 (demand > supply). Thus, the battery 21 is discharged in the same manner as in the period from the time t10 to the time t11. In this manner, the battery 21 is utilized by the charging or discharging.

In short, the electric power management apparatus 15 utilizes the battery 21 on the basis of the supply and demand balance of the electric power in the facility 1 while the vehicle 2 is electrically connected to the facility 1. For example, the electric power management apparatus 15 performs the charging or discharging of the battery 21 while maintaining the charging rate of the battery 21 within the target range R0, and stops the charging or discharging when the charging rate of the battery 21 falls outside the target range R0 (alternatively, when it falls outside the range R0).

In this way, the electric power management system SY suppresses the use of the electric power of the electric power system 9 while utilizing the battery 21 of the vehicle 2, and manages the electric power in the facility 1. Here, the target range R0 is set in advance in preparation for a case where the use of the vehicle 2 is required contrary to user's prediction. Therefore, the battery 21 is only required to be utilized in a period before the time when the user plans to use the vehicle 2, and the charging of the battery 21 is only required to be completed so that the charging rate of the battery 21 becomes a desired value (A value of at least the lower limit value V1 or more, preferably a value of the upper limit value V2 or more. For example, 100[%] or the like.) at the scheduled time.

Note that when the charging rate of the battery 21 is outside the target range R0 at the time t10, the battery 21 is charged or discharged so as to be within the target range R0. For example, when the charging rate of the battery 21 is smaller than the lower limit value VI, the battery 21 is charged, and when the charging rate of the battery 21 is larger than the upper limit value V2, the battery 21 is discharged. Thus, after the charging rate of the battery 21 falls within the target range R0, the battery 21 is utilized in the above-described procedure.

Referring again to FIG. 1, the control unit 25 enters the operating state on the basis of the electric power of the sub battery 23, and executes the charging or discharging of the battery 21 by driving and controlling the charge/discharge device 22 on the basis of the communication with the electric power management apparatus 15. On the other hand, while the battery 21 is not charged or discharged, the control unit 25 is in the resting state, and the electric power consumption of the sub battery 23 is suppressed. In other words, from the viewpoint of the electric power management apparatus 15, when starting the charging or discharging of the battery 21, the electric power management apparatus 15 operates the control unit 25 with the electric power of the sub battery 23 and instructs the control unit 25 in the operating state to start the charging or discharging. Thereafter, the electric power management apparatus 15 drives and controls the charge/discharge device 22 by the control unit 25 in the operating state on the basis of the supply and demand balance of the electric power in the facility 1 to utilize the battery 21 (continues the charging or discharging).

The electric power management apparatus 15 can receive a request for the provision of electric power (DR (demand response) from the aggregator described above) from the electric power system 9, and can execute electric power management on the basis of the request. For example, even when the electric power consumption in the facility 1 is larger than the generated electric power by the electric power generation device 1 (in the case where demand > supply), the electric power management apparatus 15 can execute the discharging of the battery 21 when the charging rate of the battery 21 is larger than the lower limit value V1 at the time of receiving the request. On the other hand, when not receiving the request, the electric power management apparatus 15 can utilize the battery 21 according to the procedure described with reference to FIG. 2.

FIG. 3 illustrates a communication mode between the electric power management apparatus 15 and an aggregator 9. The aggregator 9 has an aggregator server 91 and an aggregator gateway 92. The electric power management apparatus 15 communicates with (the control unit 25 of) the vehicle 2 on the basis of the DR received from the server 91 via the gateway 92, and can utilize the battery 21.

Note that the communication between the electric power management apparatus 15 and (the control unit 25 of) the vehicle 2 is performed by a communication method conforming to a predetermined standard, and in this embodiment, the communication is performed by a communication method conforming to the ISO/IEC15118 (or DIN70121) standard. The information communicated in this manner does not include, for example, temperature information on the vehicle 2, the battery 21, and the like.

For example, when the server 91 generates a request 311 for the provision of electric power from the facility 1 to the electric power system 9, the gateway 92 outputs a request 312 having the same content to the electric power management apparatus 15 in response to the request 311. Here, the requests 311 and 312 indicate, as an example, a request for the provision of electric power from the facility 1 to the electric power system 9, the amount of electric power, the time zone, the content of an incentive when the request is accepted, and the like.

The electric power management apparatus 15 communicates with the control unit 25 in response to the request 312, and determines whether or not the content of the request 312 (or 311) can be executed. This determination can be made on the basis of whether or not, by calculating electric power that can be transmitted from the battery 21 to the electric power system 9 (hereinafter, referred to as "transmittable electric power"), the transmittable electric power satisfies the content of the request 312. The transmittable electric power can be calculated on the basis of the electric characteristic or utilization capability of the battery 21, for example, the charging rate of the battery 21 (more specifically, a margin to the lower limit value V1 of the target range R0) and the like.

When the charging rate of the battery 21 is larger than the lower limit value V1 and the transmittable electric power satisfies the content of the request 312, the electric power management apparatus 15 outputs an instruction 313 to start the discharging of the battery 21. Thereafter, the discharging of the battery 21 (the provision of electric power from the facility 1 to the electric power system 9) is started, and during that time, the calculation of the transmittable electric power and notification 314 of the result of the calculation are performed at a predetermined cycle by the communication between the electric power management apparatus 15 and the control unit 25. In response to the notification 314, notification 315 having the same content is outputted from the electric power management apparatus 15 to the gateway 92, and notification 316 having the same content is outputted from the gateway 92 to the server 91.

In addition, for example, the electric power management apparatus 15 includes a clocking function/incorporates a timer, and measures, during the discharging of the battery 21, the time elapsed from the start of the discharging. When the result of this measurement satisfies a predetermined condition (for example, when the battery 21 is discharged for the time indicated by the request 312), the electric power management apparatus 15 outputs an instruction 317 to end the discharging of the battery 21. Thereafter/substantially simultaneously, notification 318 indicating the end of the discharging of the battery 21 is outputted from the electric power management apparatus 15 to the gateway 92, and notification 319 having the same content is outputted from the gateway 92 to the server 91.

According to such an aspect, the battery 21 is appropriately utilized, and an incentive for the battery 21 being utilized in response to the DR from the aggregator 9 can be given to the facility 1. Note that the incentive is typically financial, but is only required to be any service.

In this embodiment, the request 311 (and 312) indicates the request for the provision of electric power from the facility 1 to the electric power system 9, the amount of electric power, the time zone, the content of the incentive when the request is accepted, and the like, but the same applies to the case of providing electric power from the electric power system 9 to the facility 1. That is, as another embodiment, the request 311 may indicate a request for the provision of electric power from the electric power system 9 to the facility 1, the amount of electric power, the time zone, the content of an incentive when the request is accepted, and the like. In this case, the electric power management apparatus 15 can execute the charging of the battery 21 when the charging rate of the battery 21 is smaller than the upper limit value V2 at the time of receiving the DR from the aggregator 9.

Incidentally, it is considered that electric power actually/really transmitted from the battery 21 to the electric power system 9 (hereinafter, referred to as "actual transmission electric power") does not necessarily coincide with the transmittable electric power. One of the causes is that the electric characteristic of the battery 21 changes due to a change in the utilization environment of the battery 21. For example, in a low temperature environment such as -40 degrees or -20 degrees, the viscosity of the electrolyte solution contained in the battery 21 increases, and accordingly, the internal resistance increases, and the output voltage of the battery 21 decreases (see Japanese Patent No. 6483924).

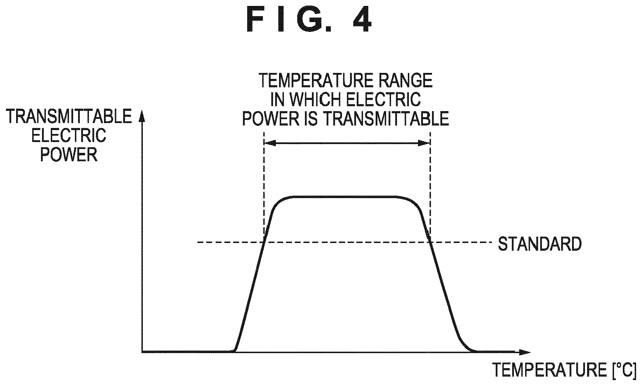

As illustrated in FIG. 4, the electric power that can be outputted from the battery 21 typically satisfies the standard within a predetermined temperature range (for example, a range of ±0 degrees to 40 degrees). Therefore, for example, when the battery 21 has a relatively low temperature or a high temperature, it becomes difficult to substantially provide electric power from the facility 1 to the electric power system 9. In such a case, even when the DR is received from the aggregator 9 while the charging rate of the battery 21 is within the target range R0, it can be said that the appropriate utilization of the battery 21 is substantially not executable. The continuing utilization of the battery 21 in such a case not only adds an unnecessary load to the battery 21, but also adds an unnecessary load to peripheral devices used for the utilization of the battery 21 such as the electric power management apparatus 15.

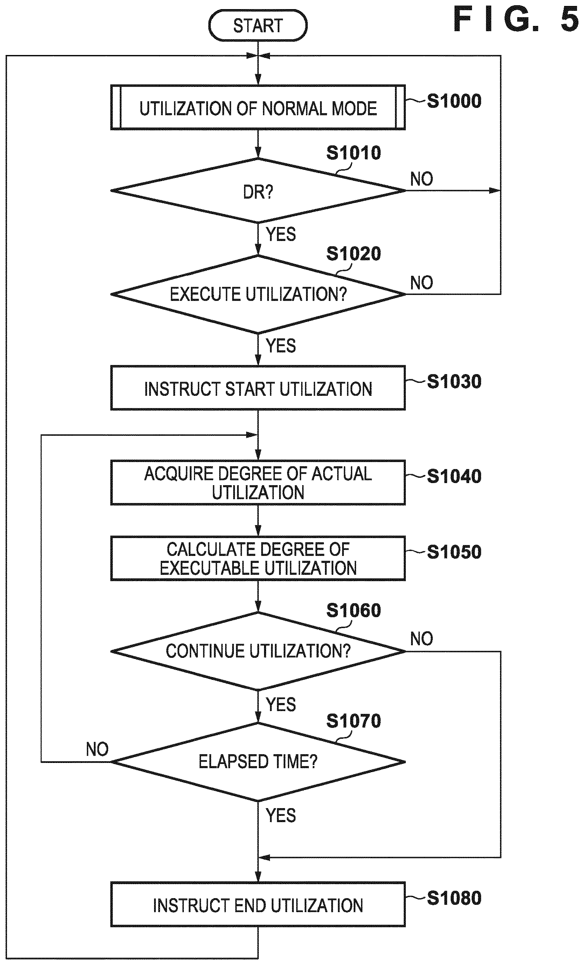

FIG. 5 is a flowchart illustrating an example of an electric power management method of the electric power management apparatus 15 in the communication mode illustrated in FIG. 3, in which the above-described situation can be prevented. Each step of this flowchart is started when the electric connection between the facility 1 and the vehicle 2 is realized (the cable of the vehicle connection mechanism 14 is connected to the vehicle 2), and is realized mainly by the electric power management apparatus 15. The outline is that the utilization of the battery 21 is started on the basis of the DR from the aggregator 9, the transmittable electric power and the actual transmission electric power are acquired at a predetermined cycle during the utilization, and the utilization is stopped on the basis of their results.

In step S1000 (Hereinafter, it is simply referred to as "S1000". The same applies to other steps described later.), the battery 21 is utilized in the mode described with reference to FIG. 2 (hereinafter, referred to as a "normal mode").

In S1010, it is determined whether or not the DR is present from the aggregator 9. If the DR is present, the process proceeds to S1020. If not, the process returns to S1000.

In S1020, a degree of the executable utilization of the battery 21 is calculated, and whether or not the content of the DR can be executed is determined on the basis of the result (see FIG. 3). In this embodiment, the transmittable electric power (the electric power that can be transmitted from the battery 21 to the electric power system 9) is calculated and acquired, and it is determined whether or not the transmittable electric power satisfies the content of the DR. If the content of the DR can be executed, the process proceeds to S1030. If not, notification indicating that the content of the DR cannot be executed is outputted to the aggregator 9, and the process returns to S1000.

In S1030, an instruction to start the utilization of the battery 21 (the instruction 313 in FIG. 3) is outputted so that the content of the DR is executed. In this embodiment, the discharging of the battery 21 is started in the mode (hereinafter, referred to as a "DR mode") described with reference to FIG. 3.

In S1040, a degree of the actual utilization of the battery 21 is measured, and the result is acquired. In this embodiment, the actual transmission electric power (the electric power actually/really transmitted from the battery 21 to the electric power system 9) is measured and acquired.

In S1050, a degree of the executable utilization (here, the transmittable electric power) of the battery 21 is calculated and acquired in a similar procedure to S1020.

In S1060, the result of the measurement in S1040 (here, the actual transmission electric power) is compared with the result of the calculation in S1050 (here, the transmittable electric power), and it is determined, on the basis of the result of the comparison of them, whether or not the utilization of the battery 21 can be continued. When the utilization of the battery 21 can be continued, the process proceeds to S1070. If not, the process proceeds to S1080.

Here, the determination in S1060 is only required to be made on the basis of whether or not a predetermined condition is satisfied. Examples of the condition include that a difference between the actual transmission electric power and the transmittable electric power is larger than a reference value. Other examples include:
that the actual transmission electric power is smaller/becomes smaller than a reference value (it is substantially 0); and
that the transmittable electric power is smaller/becomes smaller than a reference value (it is substantially 0).

In this case, the determination in S1060 is performed on the basis of one of the result of the measurement in S1040 and the result of the calculation in S1050.

In S1070, it is determined whether or not the time indicated by the DR (here, the time indicated by the request 311 or 312 in FIG. 3) has elapsed from the start of the utilization of the battery 21. If the time indicated by the DR has elapsed, the process proceeds to S1080. If not, the process returns to S1040.

In S1080, an instruction to end the utilization of the battery 21 (the instruction 317 in FIG. 3) is outputted, and the process returns to S1000. In this embodiment, this completes the discharging of the battery 21 in the DR mode.

In short, while not receiving the DR from the aggregator 9, the electric power management apparatus 15 charges or discharges the battery 21 in the normal mode (see S1000). When receiving the DR from the aggregator 9, the electric power management apparatus 15 charges or discharges the battery 21 in the DR mode (see S1020 to S1080).

In S1020, the degree of the charging or discharging executable for the battery 21 is calculated, and on the basis of the calculation result, an instruction to charge or discharge the battery 21 is outputted in S1030. During the execution of the charging or discharging of the battery 21, the degree of the charging or discharging of the battery 21 that is actually being executed is acquired in S1040, and the degree of the charging or discharging executable for the battery 21 is calculated in S1050. Then, in S1060, the charging or discharging of the battery 21 is stopped on the basis of a difference between the result of the calculation in S1050 and the result of the acquisition in S1040.

According to this embodiment, it is possible to reduce an unnecessary load that can be applied to the battery 21 (and the peripheral devices used for the utilization thereof, for example, the electric power management apparatus 15 and the like), and the battery 21 can be appropriately utilized. Alternatively/incidentally, a signal corresponding to the difference described above (the difference between the result of the calculation in S1050 and the result of the acquisition in S1040) or a signal indicating the difference may be transmitted to the aggregator 9. The aggregator 9 can also update the DR in response to the signal, and such an aspect can also reduce the unnecessary load that can be applied to the battery 21.

In the above description, for ease of understanding, each element is indicated by a name related to its functional aspect, but each element is not limited to one having the content described in the embodiment as a main function, and may be one having the content supplementarily.

Some features of the embodiment are summarized below:
A first aspect relates to an electric power management apparatus (for example, 15). The electric power management apparatus manages electric power in a facility (for example, 1) configured to be electrically connectable to a vehicle (for example, 2) including a battery (for example, 21). The electric power management apparatus includes a calculation unit (for example, S1020 and S1050) that calculates a degree of charging or discharging executable for the battery, an instruction unit (for example, S1030) that gives an instruction on the charging or discharging, an acquisition unit (for example, S1040) that acquires a degree of the charging or discharging that is actually being executed in response to the instruction of the instruction unit, and a stopping unit (for example, S1060) that stops the charging or discharging executed in response to the instruction of the instruction unit on the basis of a difference between the calculated degree and the acquired degree. Thus, an unnecessary load that can be applied to the battery can be reduced, and the battery can be appropriately utilized.

In a second aspect, the stopping unit stops the charging or discharging when the difference between the calculated degree and the acquired degree is larger than a reference value. Thus, the first aspect can be appropriately realized.

In a third aspect, the stopping unit stops the charging or discharging when the acquired degree is smaller than a reference value. Thus, the first aspect can be appropriately realized.

A fourth aspect relates to an electric power management apparatus (for example, 15). The electric power management apparatus manages electric power in a facility (for example, 1) configured to be electrically connectable to a vehicle (for example, 2) including a battery (for example, 21). The electric power management apparatus includes a reception unit (for example, S1010) that receives a request for charging or discharging for the battery from outside (for example, the aggregator 9), a calculation unit (for example, S1020 and S1050) that calculates a degree of the executable charging or discharging, an instruction unit (for example, S1030) that gives an instruction on the charging or discharging in response to the request received by the reception unit, an acquisition unit (for example, S1040) that acquires a degree of the charging or discharging that is actually being executed in response to the instruction of the instruction unit, and a transmission unit that transmits a signal corresponding to a difference between the calculated degree and the acquired degree to the outside. According to such an aspect as well, the battery can be appropriately utilized.

In a fifth aspect, a stopping unit (for example, S1060) that stops the charging or discharging when the difference between the calculated degree and the acquired degree is larger than a reference value is further included. Thus, effects similar to those of the first aspect can be obtained.

In a sixth aspect, a stopping unit (for example, S1060) that stops the charging or discharging when the acquired degree is smaller than a reference value is further included. Thus, effects similar to those of the first aspect can be obtained.

In a seventh aspect, during the execution of the charging or discharging, the calculation unit calculates the degree at a predetermined cycle, and the acquisition unit acquires the degree at a predetermined cycle. Thus, the utilization mode of the battery can be made according to the elapse of time.

An eighth aspect relates to an electric power management apparatus (for example, 15). The electric power management apparatus manages electric power in a facility (for example, 1) configured to be electrically connectable to a vehicle (for example, 2) including a battery (for example, 21). The electric power management apparatus includes a calculation unit (for example, S1020 and S1050) that calculates a degree of discharging executable for the battery, an instruction unit (for example, S1030) that gives an instruction on the discharging, an acquisition unit (for example, S1040) that acquires a degree of the discharging that is actually being executed in response to the instruction of the instruction unit, and a stopping unit (for example, S1060) that stops the discharging executed in response to the instruction of the instruction unit on the basis of a difference between the calculated degree and the acquired degree. Thus, effects similar to those of the first aspect can be obtained.

A ninth aspect relates to an electric power management system (for example, SY). The electric power management system includes the electric power management apparatus (for example, 15) and a vehicle (for example, 2) including the battery. That is, the above-described electric power management apparatus can be applied to various facilities that are electrically connectable to vehicles.

In a tenth aspect, the electric power management apparatus further includes a communication unit for communicating with the vehicle, and the information of the communication by the communication unit does not include temperature information (for example, the standard such as ISO/IEC15118). That is, the above-described aspect can be appropriately realized in the above-described electric power management system regardless of the change in the utilization environment of the battery.

The invention is not limited to the foregoing embodiments, and various variations/changes are possible within the spirit of the invention.
An electric power management apparatus that manages electric power in a facility configured to be electrically connectable to a vehicle including a battery, the electric power management apparatus comprising a calculation unit that calculates a degree of charging or discharging executable for the battery, an instruction unit that gives an instruction on the charging or discharging, an acquisition unit that acquires a degree of the charging or discharging that is actually being executed in response to the instruction of the instruction unit, and a stopping unit that stops the charging or discharging executed in response to the instruction of the instruction unit on the basis of a difference between the calculated degree and the acquired degree.

## Claims

1. An electric power management apparatus that manages electric power in a facility configured to be electrically connectable to a vehicle including a battery, the electric power management apparatus comprising:
a calculation unit that calculates a degree of charging or discharging executable for the battery;
an instruction unit that gives an instruction on the charging or discharging;
an acquisition unit that acquires a degree of the charging or discharging that is actually being executed in response to the instruction of the instruction unit; and
a stopping unit that stops the charging or discharging executed in response to the instruction of the instruction unit on the basis of a difference between the calculated degree and the acquired degree.

2. The electric power management apparatus according to claim 1, wherein
the stopping unit stops the charging or discharging when the difference between the calculated degree and the acquired degree is larger than a reference value.

3. The electric power management apparatus according to claim 1, wherein
the stopping unit stops the charging or discharging when the acquired degree is smaller than a reference value.

4. An electric power management apparatus that manages electric power in a facility configured to be electrically connectable to a vehicle including a battery, the electric power management apparatus comprising:
a reception unit that receives a request for charging or discharging for the battery from outside;
a calculation unit that calculates a degree of the executable charging or discharging;
an instruction unit that gives an instruction on the charging or discharging in response to the request received by the reception unit;
an acquisition unit that acquires a degree of the charging or discharging that is actually being executed in response to the instruction of the instruction unit; and
a transmission unit that transmits a signal corresponding to a difference between the calculated degree and the acquired degree to the outside.

5. The electric power management apparatus according to claim 4, further comprising
a stopping unit that stops the charging or discharging when the difference between the calculated degree and the acquired degree is larger than a reference value.

6. The electric power management apparatus according to claim 4, further comprising
a stopping unit that stops the charging or discharging when the acquired degree is smaller than a reference value.

7. The electric power management apparatus according to any one of claims 1 to 6, wherein
during the execution of the charging or discharging, the calculation unit calculates the degree at a predetermined cycle, and the acquisition unit acquires the degree at a predetermined cycle.

8. An electric power management apparatus that manages electric power in a facility configured to be electrically connectable to a vehicle including a battery, the electric power management apparatus comprising:
a calculation unit that calculates a degree of discharging executable for the battery;
an instruction unit that gives an instruction on the discharging;
an acquisition unit that acquires a degree of the discharging that is actually being executed in response to the instruction of the instruction unit; and
a stopping unit that stops the discharging executed in response to the instruction of the instruction unit on the basis of a difference between the calculated degree and the acquired degree.

9. An electric power management system comprising:
the electric power management apparatus according to any one of claims 1 to 8; and
a vehicle including the battery.

10. The electric power management system according to claim 9, wherein
the electric power management apparatus further includes a communication unit for communicating with the vehicle, and
the information of the communication by the communication unit does not include temperature information.
